# EUROPÄISCHE PATENTANMELDUNG

(11) **EP 3 376 602 A1**
(43) Veröffentlichungstag der Anmeldung: **19.09.2018**
(21) Anmeldenummer: 17161674.1
(22) Anmeldetag: 17.03.2017
(51) Int. Cl.: H01R 12/70, H01R 13/622, H01L 31/06, H01L 25/16, H01L 25/18, H01R 13/703, H01R 13/514, H01R 13/6585

(54) **SICHERHEITSTECHNISCHES ELEKTRONIKMODUL**

(71) Anmelder: EUCHNER GmbH + Co. KG, 70771 Leinfelden-Echterdingen (DE)
(72) Erfinder: Wilpert, Dominik, 70199 Stuttgart (DE)
(74) Vertreter: Ruckh, Rainer Gerhard

(57) **Zusammenfassung**

Die Erfindung betrifft ein Sicherheitstechnisches Elektronikmodul mit einem elektrischen Anschluss (3). Der elektrische Anschluss (3) umfasst ein Teilgewinde (10), welches Bestandteil eines elektrisch leitfähigen, eine elektrische Schirmung ausbildenden Bauteils ist.

## Beschreibung

Die Erfindung betrifft ein sicherheitstechnisches Elektronikmodul gemäß dem Oberbegriff des Anspruchs 1.

Derartige sicherheitstechnische Elektronikmodule bilden generell Einheiten mit vorzugsweise in einem Gehäuse integrierten elektrischen und/oder elektronischen Bauelementen, welche zur Bereitstellung sicherheitsrelevanter Funktionen im Bereich der Sicherheitstechnik eingesetzt werden.

Ein Beispiel für ein derartiges sicherheitstechnisches Elektronikmodul ist ein Sicherheitsschalter, der insbesondere als Zugangssicherung zu einem Gefahrenbereich eingesetzt wird. Beispielsweise kann ein Sicherheitsschalter zur Verriegelung einer Schutztür als Zugang zu einem Gefahrenbereich eingesetzt werden. Der Betrieb einer gefahrbringenden Anlage innerhalb des Gefahrenbereichs wird mittels einer Sicherheitsteuerung nur dann freigegeben, wenn die Schutztür mittels des Sicherheitsschalters verriegelt ist. Der Sicherheitsschalter ist direkt oder über ein Schnittstellenmodul als weiteres sicherheitstechnisches Elektronikmodul an die Sicherheitssteuerung angeschlossen.

Der Erfindung liegt die Aufgabe zugrunde, ein sicherheitstechnisches Elektronikmodul der eingangs genannten Art hinsichtlich seiner Anschlusstechnik zu verbessern.

Zur Lösung dieser Aufgabe sind die Merkmale des Anspruchs 1 vorgesehen. Vorteilhafte Ausführungsformen und zweckmäßige Weiterbildungen der Erfindung und in den abhängigen Ansprüchen beschrieben.

Die Erfindung betrifft ein sicherheitstechnisches Elektronikmodul mit einem elektrischen Anschluss. Der elektrische Anschluss umfasst ein Teilgewinde, welches Bestandteil eines elektrisch leitfähigen, eine elektrische Schirmung ausbildenden Bauteils ist.

Bei dem erfindungsgemäßen sicherheitstechnischen Elektronikmodul handelt es sich allgemein um eine Baueinheit mit elektrischen und/oder elektronischen Bauelementen, wobei mit diesem sicherheitstechnischen Elektronikmodul sicherheitsrelevante Funktionen realisiert werden. Insbesondere kann das sicherheitstechnische Elektronikmodul von einem Sicherheitsschalter gebildet sein. Weiterhin kann das sicherheitstechnische Elektronikmodul von einem Schnittstellenmodul gebildet sein, mittels dessen ein oder mehrere Sicherheitsschalter an eine übergeordnete Einheit wie eine Sicherheitssteuerung angeschlossen werden können.

Erfindungsgemäß weist das sicherheitstechnische Elektronikmodul einen elektrischen Anschluss mit einem Teilgewinde auf. Ein an den elektrischen Anschluss anzuschließendes elektrisches Anschlusselement weist ein zum Teilgewinde passendes Gewinde auf, welches an dem Teilgewinde anschraubbar ist.

Das erfindungsgemäß vorgesehene Teilgewinde, das vorzugsweise als Innengewinde ausgebildet ist, weist gegenüber Vollgewinden signifikante fertigungstechnische Vorteile auf. Derartige Vollgewinde werden typischerweise durch Ausspindeln bei Gießvorgängen hergestellt, was aufwändige Gießwerkzeuge erfordert. Weiterhin können Vollgewinde durch Gewindeschneiden hergestellt werden, was ebenfalls aufwändig ist.

Demgegenüber kann das Teilgewinde rationell dadurch hergestellt werden, dass dieses an das Bauteil angegossen wird. Die Herstellung des Teilgewindes kann damit ohne großen Mehraufwand in den Gießvorgang zur Herstellung des Bauteils integriert werden.

Das Bauteil, welches das Teilgewinde umfasst, besteht dabei aus einem elektrisch leitfähigen, insbesondere metallischen Werkstoff. Dieses Bauteil bildet ein Gussteil, beispielsweise ein Zink-Druckgussteil. Während des Gießvorgangs zur Herstellung des Bauteils kann das Teilgewinde an das Bauteil angegossen werden, sodass keine separaten weiteren Fertigungsschritte zur Herstellung des Bauteils erforderlich sind.

Ein wesentlicher Vorteil besteht darin, dass durch die elektrische Leitfähigkeit des Bauteils dieses die Funktion einer elektrischen Schirmung übernehmen kann, sodass keine separaten Teile für die elektrische Schirmung des Teilgewindes und damit des elektrischen Anschlusses notwendig sind.

Gemäß einer besonders vorteilhaften Ausgestaltung der Erfindung erstreckt sich das Teilgewinde über einen Teilwinkelbereich von 360°. Innerhalb des verbleibenden, vom Teilgewinde ausgesparten Restwinkelbereichs ist ein konzentrisch zum Teilgewinde angeordnetes Teilkreissegment vorgesehen.

Da sich das Teilgewinde nicht über den vollen Winkelbereich von 360° erstreckt, sondern nur über einen Teilwinkelbereich hiervon, kann bei Herstellen der Schraubverbindung zwischen dem Teilgewinde des elektrischen Anschlusses des sicherheitstechnischen Elektronikmoduls und dem Gewinde des elektrischen Anschlusselements gegebenenfalls kein ausreichender Kontakt zwischen Gewinde und Teilgewinde vorliegen. Da sich damit das Gewinde unkontrolliert relativ zum Teilgewinde bewegen kann, kann das Aufschrauben des Gewindes auf das Teilgewinde erschwert sein oder im Extremfall überhaupt nicht mehr möglich sein. Diese mögliche Funktionsbeeinträchtigung wird auf einfache Weise durch das Teilkreissegment verhindert, das zusammen mit dem Teilgewinde eine sichere Führung des Gewindes ermöglicht.

Bei einem Teilgewinde in Form eines Innengewindes bildet das Teilgewinde den ersten Teil einer Ringstruktur der durch das Teilkreissegment als weitere Ringstruktur ergänzt wird. Generell weist nur die Innenseite des Teilgewindes eine Gewindestruktur auf, nicht aber das Teilkreissegment, das lediglich als Gegenlager und Führungselement dient.

Das Teilkreissegment kann sich prinzipiell über den gesamten, vom Teilgewinde nicht abgedeckten Restwinkelbereich erstrecken. Bei einem Teilgewinde in Form eines Innengewindes bildet dann das Teilgewinde mit dem Teilkreissegment eine geschlossene Ringstruktur, in welche ein Außengewinde eines elektrischen Anschlusselements eingeschraubt werden kann. Um eine sichere Führung des Außengewindes zu gewährleisten, muss sich jedoch das Teilkreissegment nicht über den gesamten Restwinkelbereich erstrecken. In einem solchen Fall verbleiben kleinere Lücken zwischen Teilgewinde und Teilkreissegment, die jedoch für eine einwandfreie Führung des Außengewindes oder allgemein des Gewindes unkritisch sind.

Gemäß einer vorteilhaften Ausführungsform erstreckt sich das Teilgewinde über einen Teilwinkelbereich von kleiner oder gleich 180°.

Dadurch ergibt sich ein weiterer fertigungstechnischer Vorteil derart, dass das Angießen des Teilgewindes an das Bauteil ohne Zusatzeinrichtungen im Gusswerkzeug, wie zum Beispiel Schiebern, erfolgen kann. Diese Vereinfachung des Gusswerkzeugs ergibt sich weiterhin auch dadurch, dass das Teilgewinde orthogonal zur Hauptentformrichtung liegt. Das Gussteil, bestehend aus dem Bauteil mit dem Teilgewinde, kann dann ohne jegliche mechanische Nacharbeit und damit allein in einem Gießvorgang hergestellt werden.

Gemäß einer konstruktiv vorteilhaften Ausgestaltung der Erfindung besteht das Gehäuse aus einer Bodenplatte und einem Gehäusedeckel. Die Montage des Gehäuses erfolgt dann einfach dadurch, dass nach der Bestückung der elektrischen und elektronischen Bauteile insbesondere auf der Bodenplatte nur noch der Gehäusedeckel auf die Bodenplatte aufgesetzt und an dieser befestigt werden muss. Bei dieser Ausführungsform ist das Bauteil mit dem Innengewinde Bestandteil der Bodenplatte. Diese Einheit kann in einem einzigen Gussvorgang hergestellt werden.

Das Teilkreissegment ist dann vorteilhaft Bestandteil des Gehäusedeckels, wobei dieses Teilkreissegment vorteilhaft an einem Element des Gehäuseelements angegossen wird. Damit kann auch der Gehäusedeckel mit dem Teilkreissegment rationell in einem Gießvorgang gefertigt werden. Der Gehäusedeckel kann dabei allgemein aus einem metallischen Werkstoff oder auch aus Kunststoff bestehen.

Der elektrische Anschluss des sicherheitstechnischen Elektronikmoduls kann in unterschiedlichen Konfigurationen ausgebildet sein. Insbesondere kann der elektrische Anschluss als Stecker oder Buchse ausgebildet sein, wobei dann komplementär hierzu das elektrische Anschlusselement als Buchse oder Stecker ausgebildet ist.

Die Erfindung wird im Folgenden anhand der Zeichnungen erläutert. Es zeigen:
- Figur 1:: Außenansicht eines Schnittstellenmoduls als Ausführungsbeispiel des erfindungsgemäßen sicherheitstechnischen Elektronikmoduls.
- Figur 2:: Schnittstellenmodul gemäß Figur 1 bei von einer Bodenplatte abgenommenem Gehäusedeckel.
- Figur 3:: Schnittstellenmodul gemäß Figur 1 mit zwei daran angeschlossenen elektrischen Anschlüssen.
- Figur 4:: Einzeldarstellung eines elektrischen Anschlusses des Schnittstellenmoduls gemäß Figur 1.
- Figur 5:: Erstes Beispiel eines Teilgewindes mit einem zugeordneten Teilkreissegment für das Schnittstellenmodul gemäß Figur 1.
a) in einer Draufsicht
b) in einer Seitenansicht
- Figur 6:: Zweites Beispiel eines Teilgewindes mit einem zugeordneten Teilkreissegment für das Schnittstellenmodul gemäß Figur 1
a) in einer Draufsicht
b) in einer Seitenansicht

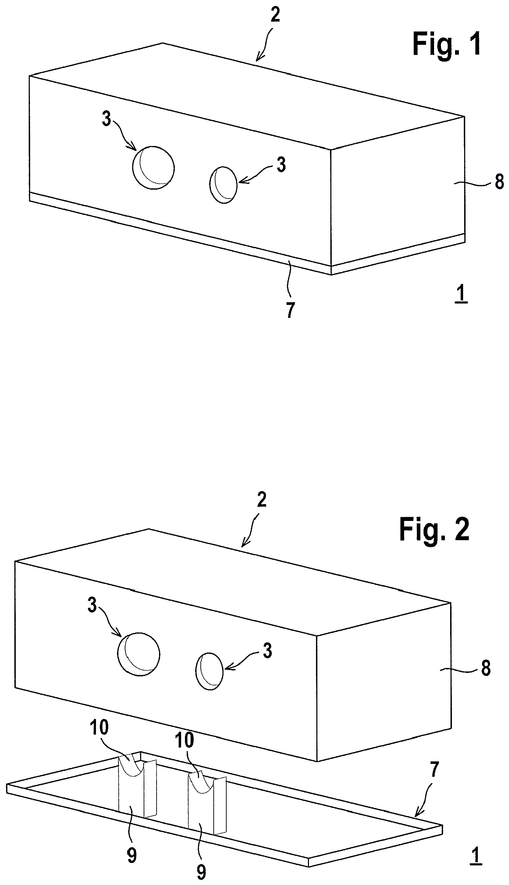

Die Figuren 1 - 3 zeigen als Ausführungsbeispiel des erfindungsgemäßen sicherheitstechnischen Elektronikmoduls ein Schnittstellenmodul 1. Das Schnittstellenmodul 1 erfüllt eine sicherheitstechnische Funktion derart, dass ein Sicherheitsschalter oder mehrere Sicherheitsschalter über dieses Schnittstellenmodul 1 an eine übergeordnete Einheit wie eine Sicherheitssteuerung angeschlossen werden können. Der oder die Sicherheitsschalter sowie die Sicherheitssteuerung sind in den Figuren 1 - 3 nicht dargestellt. Das Schnittstellenmodul 1 erfüllt eine Übersetzungsfunktion derart, dass Datenprotokolle des Sicherheitsschalters oder der Sicherheitsschalter an Datenprotokolle der Sicherheitssteuerung angepasst werden. Hierzu sind in dem Gehäuse 2 des sicherheitstechnischen Elektronikmoduls entsprechende elektronische und/oder elektrische Bauelemente integriert.

Abweichend zu dem Ausführungsbeispiel der Figuren 1 - 3 kann das erfindungsgemäße sicherheitstechnische Elektronikmodul auch von einem Sicherheitsschalter gebildet sein.

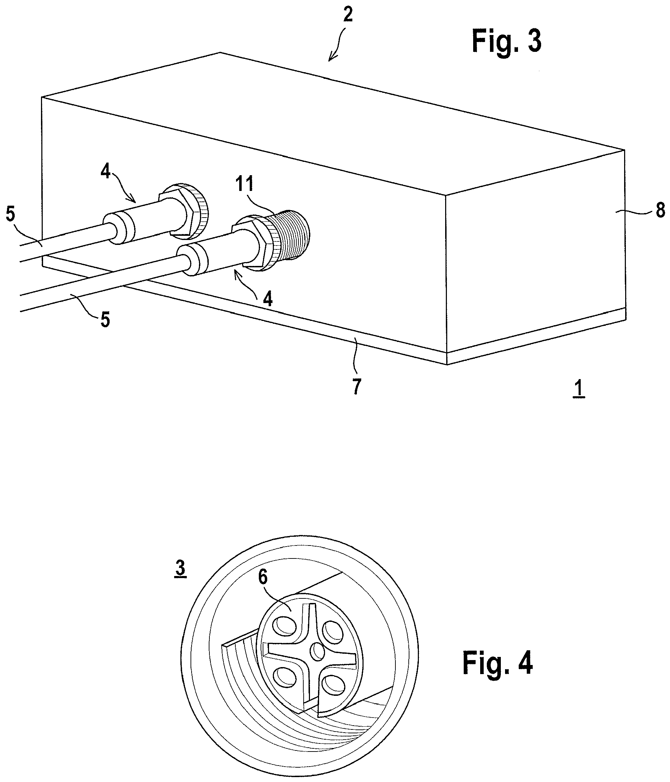

An einer Wand des Gehäuses 2 des Schnittstellenmoduls 1 münden zwei elektrische Anschlüsse 3 aus. Generell kann auch eine andere Anzahl von elektrischen Anschlüssen 3 vorgesehen sein. Wie Figur 3 zeigt, kann an jeden der elektrischen Anschlüsse 3 ein elektrisches Anschlusselement 4 angeschlossen sein, wobei an jedem elektrischen Anschluss 3 ein Kabel 5 ausmündet. Das Kabel 5 eines elektrischen Anschlusselements 4 führt zu einem Sicherheitsschalter. Das Kabel 5 des anderen elektrischen Anschlusselements 4 führt zu der Sicherheitssteuerung.

Jeder elektrische Anschluss 3 des Schnittstellenmoduls 1 ist im vorliegenden Fall in Form einer Buchse ausgebildet. Figur 4 zeigt in einer Detaildarstellung einen so gebildeten elektrischen Anschluss 3 mit einer innenliegenden Kontaktbuchse 6. Entsprechend sind die elektrischen Anschlusselemente 4 als Stecker ausgebildet.

Alternativ können die elektrischen Anschlüsse 3 als Stecker und die elektrischen Anschlusselemente 4 als Buchsen ausgebildet sein.

Das Gehäuse 2 besteht aus einer Bodenplatte 7 und einem Gehäusedeckel 8. Zur Montage des Schnittstellenmoduls 1 wird nach der Bestückung der Bodenplatte 7 mit elektrischen oder elektronischen Bauelementen der Gehäusedeckel 8 auf die Bodenplatte 7 aufgesteckt und an dieser befestigt. Hierzu sind an der Bodenplatte 7 und dem Gehäusedeckel 8 geeignete Befestigungsmittel wie Rastmittel, Verschraubungen und dergleichen vorgesehen. Die einzelnen Bauelemente und die einzelnen Befestigungsmittel sind in den Figuren nicht dargestellt.

Figur 1 zeigt den Sicherheitsschalter im fertig montierten Zustand, in welchem der Gehäusedeckel 8 auf die Bodenplatte 7 aufgesetzt und an dieser befestigt ist. Figur 2 zeigt das Schnittstellenmodul 1 bei von der Bodenplatte 7 abgenommenem Gehäusedeckel 8.

Die Bodenplatte 7 besteht aus einem Gussteil, wobei dieses Gussteil aus einem elektrisch leitfähigen Werkstoff besteht. Vorteilhaft besteht die Bodenplatte 7 aus einem Zink-Druckgussteil.

Der Gehäusedeckel 8 besteht ebenfalls aus einem Gussteil. Der Gehäusedeckel 8 kann aus einem metallischen Werkstoff oder aus einem Kunststoff bestehen.

Wie aus Figur 2 ersichtlich, stecken an der Oberseite der Bodenplatte 7 zwei identisch ausgebildete Bauteile in Form von Sockeln 9 hervor. Jeder Sockel 9 weist eine quaderförmige Kontur auf, wobei die Sockel 9 senkrecht zur ebenen Oberseite der Bodenplatte 7 orientiert sind.

Am oberen Rand jedes Sockels 9 befindet sich ein Teilgewinde 10, das im vorliegenden Fall als Innengewinde ausgebildet ist.

Die Sockel 9 mit dem Teilgewinde 10 sind einstückig mit der Bodenplatte 7 ausgebildet und werden als Gussteil in einem Gießvorgang hergestellt. Da sich jedes Teilgewinde 10, wie Figur 2 zeigt, nicht über den vollen Winkelbereich von 360° erstreckt, sondern nur über einen Teilwinkelbereich von 180° (oder weniger) und da jedes Teilgewinde 10 orthogonal zur Hauptentformrichtung des Gusswerkzeugs, das zur Herstellung des Gussteils verwendet wird, orientiert ist, brauchen im Gusswerkzeug keine konstruktiven Zusatzeinrichtungen wie zum Beispiel Schieber vorgesehen werden. Weiterhin kann die Bodenplatte 7 mit den Sockeln 9 und Teilgewinden 10 als Gussteil hergestellt werden, ohne dass für dieses mechanische Nacharbeiten notwendig sind.

Jedes Teilgewinde 10 ist Bestandteil des entsprechenden elektrischen Anschlusses 3 des Schnittstellenmoduls 1. Da das Teilgewinde 10 Bestandteil des aus leitfähigem Material bestehenden Sockels 9 ist, wird dadurch eine elektrische Schirmung des elektrischen Anschlusses 3 realisiert, ohne dass hierfür zusätzliche Bauteile benötigt werden.

Jedes Teilgewinde 10 eines elektrischen Anschlusses 3 dient zur Befestigung eines am elektrischen Anschluss 3 anzuschließenden elektrischen Anschlusselements 4. Das elektrische Anschlusselement 4 weist ein zum Teilgewinde 10 korrespondierendes Außengewinde 11 auf.

Zur Befestigung des elektrischen Anschlusselements 4 am elektrischen Anschluss 3 wird das Außengewinde 11 des elektrischen Anschlusselements 4 auf das Teilgewinde 10 aufgeschraubt.

Da sich das Teilgewinde 10 nur über einen Teilwinkelbereich von 180° erstreckt, würde die Gefahr bestehen, dass sich beim Aufschrauben das Außengewinde 11 vom Teilgewinde 10 löst, wodurch das Aufschrauben behindert würde.

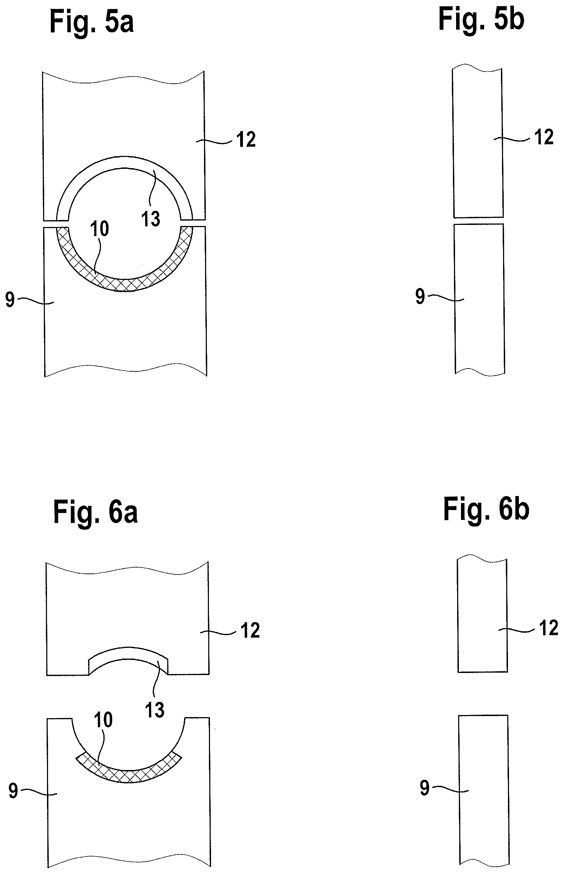

Um dies zu vermeiden ist die in den Figuren 5a, 5b dargestellte Konstruktion vorgesehen. Diese Konstruktion ist in identischer Weise für beide elektrische Anschlüsse 3 des Schnittstellenmoduls 1 vorgesehen.

Figur 5a zeigt in einer Draufsicht einen Sockel 9 mit einem Teilgewinde 10, das am oberen Rand des Sockels 9 angeordnet ist und sich über den Teilwinkelbereich von 180° erstreckt. Dem Sockel mit dem Teilgewinde 10 ist ein Element 12 dem Gehäusedeckel 8 zugeordnet. Dieses Element 12 ist einstückig mit dem restlichen Gehäusedeckel 8 ausgebildet, das heißt der Gehäusedeckel 8 mit den beiden Elementen 12 ist von einem Gussteil gebildet.

Am unteren Rand des Elements 12 ist ein Teilkreissegment 13 vorgesehen. Das Teilkreissegment 13 bildet ein Ringsegment, das sich über einen Restwinkelbereich von 180° erstreckt.

Die Mantelfläche des Teilkreissegments 13 ist glatt ausgebildet, das heißt sie bildet kein Gewinde aus.

Das Teilkreissegment 13 wird beim Gießvorgang zur Herstellung des Gehäusedeckels 8 an das Element 12 angegossen, das heißt die Herstellung des Teilkreissegments 13 erfolgt bei dem Gießvorgang selbst. Damit sind zur Herstellung des Teilkreissegments 13 keine separaten Fertigungsschritte notwendig.

Die Figuren 5a, 5b zeigen den Sockel 9 und das zugeordnete Element 12 des Gehäusedeckels 8 wenn der Gehäusedeckel 8 auf die Bodenplatte 7 aufgesetzt und an diesem befestigt ist.

Wie Figur 5a zeigt, liegt das Element 12 mit dem Teilkreissegment 13 dicht oberhalb des Sockels 9 mit dem Teilgewinde 10, sodass sich das Teilgewinde 10 und das konzentrisch zu diesem angeordneten Teilkreissegment 13 zu einem geschlossenen Ring ergänzen. Dies wird erreicht durch die Anpassung des Teilkreissegments 13 an das Teilgewinde 10 derart, dass sich das Teilgewinde 10 über den Teilwinkelbereich von 180° erstreckt und das Teilkreissegment 13 sich komplett über den vom Teilgewinde 10 freigelassenen Restwinkelbereich von ebenfalls 180° erstreckt.

Der Innendurchmesser des von dem Teilkreissegment 13 und von dem Teilgewinde 10 gebildeten Rings ist an den Außendurchmesser des Außengewindes angepasst, sodass das Außengewinde spielarm in diesen Ring geführt ist.

Wie Figur 5b zeigt, sind dann, wenn der Gehäusedeckel 8 auf die Bodenplatte 7 aufgesetzt ist, der Sockel 9 und das Element 12 übereinander angeordnet. Dadurch bildet sich eine hohlzylindrische Aufnahme für das Außengewinde 11 des elektrischen Anschlusselements 4.

Durch diese Konstruktion kann das Außengewinde 11 am Teilgewinde 10 festgeschraubt werden ohne dass die Gefahr besteht, dass sich beim Schraubvorgang das Außengewinde 11 vom Teilgewinde 10 löst, da das Teilkreissegment 13 als Gegenlager wirkt.

Die Figuren 6a, 6b zeigen eine Variante der Konstruktion der Figuren 5a, 5b. Die Konstruktion der Figuren 6a, 6b unterscheidet sich von der Ausführungsform der Figuren 5a, 5b nur dadurch, dass sich das Teilkreissegment 13 nicht mehr über den gesamten vom Teilgewinde 10 freigelassenen Restwinkelbereich erstreckt, sondern nur über einen Teilbereich hierzu. Entsprechend ergänzen sich das Teilgewinde 10 und das Teilkreissegment 13 nicht mehr zu einem vollständig geschlossenen Ring.

Vielmehr verbleiben nun Lücken zwischen dem Teilkreissegment 13 und dem Teilgewinde 10. Diese Lücken sind jedoch für eine kontrollierte Führung des Außengewindes 11 unkritisch, da das Teilkreissegment 13 dem Teilgewinde 10 diametral gegenüberliegend angeordnet ist und somit ein Gegenlager bildet, welches das Außengewinde 11 beim Schraubvorgang in Eingriff mit dem Teilgewinde 10 hält.

### Bezugszeichenliste

- (1): Schnittstellenmodul
- (2): Gehäuse
- (3): Elektrischer Anschluss
- (4): Elektrisches Anschlusselement
- (5): Kabel
- (6): Kontaktbuchse
- (7): Bodenplatte
- (8): Gehäusedeckel
- (9): Sockel
- (10): Teilgewinde
- (11): Außengewinde
- (12): Element
- (13): Teilkreissegment

## Patentansprüche

1. Sicherheitstechnisches Elektronikmodul mit einem elektrischen Anschluss (3), **dadurch gekennzeichnet, dass** der elektrische Anschluss (3) ein Teilgewinde (10) umfasst, welches Bestandteil eines elektrisch leitfähigen, eine elektrische Schirmung ausbildenden Bauteils ist.

2. Sicherheitstechnisches Elektronikmodul nach Anspruch 1, **dadurch gekennzeichnet, dass** das Teilgewinde (10) ein Innengewinde ist.

3. Sicherheitstechnisches Elektronikmodul nach einem der Ansprüche 1 oder 2, **dadurch gekennzeichnet, dass** sich das Teilgewinde (10) über einen Teilwinkelbereich von 360° erstreckt und dass innerhalb des verbleibenden, vom Teilgewinde (10) ausgesparten Restwinkelbereichs verlaufend ein konzentrisch zum Teilgewinde (10) angeordnetes Teilkreissegment (13) vorgesehen ist.

4. Sicherheitstechnisches Elektronikmodul nach Anspruch 3, **dadurch gekennzeichnet, dass** sich das Teilkreissegment (13) über den gesamten Restwinkelbereich oder einen Teil hiervon erstreckt.

5. Sicherheitstechnisches Elektronikmodul nach einem der Ansprüche 3 oder 4, **dadurch gekennzeichnet, dass** der Teilwinkelbereich kleiner oder gleich 180° ist.

6. Sicherheitstechnisches Elektronikmodul nach einem der Ansprüche 1 - 5 **dadurch gekennzeichnet, dass** das Bauteil, welches das Teilgewinde (10) ausbildet, aus einem elektrisch leitfähigen Werkstoff besteht.

7. Sicherheitstechnisches Elektronikmodul nach einem der Ansprüche 1 - 6, **dadurch gekennzeichnet, dass** das Bauteil, welches das Teilgewinde (10) ausbildet, Bestandteil einer Bodenplatte (7) eines Gehäuses (2) ist.

8. Sicherheitstechnisches Elektronikmodul nach einem der Ansprüche 1 - 7, **dadurch gekennzeichnet, dass** das Teilgewinde (10) an das Bauteil angegossen ist.

9. Sicherheitstechnisches Elektronikmodul nach einem der Ansprüche 1 - 8, **dadurch gekennzeichnet, dass** das Teilkreissegment (13) Bestandteil eines Gehäusedeckels (8) ist.

10. Sicherheitstechnisches Elektronikmodul nach Anspruch 9, **dadurch gekennzeichnet, dass** das Teilkreissegment (13) an einem Element (12) des Gehäusedeckels (8) angegossen ist.

11. Sicherheitstechnisches Elektronikmodul nach einem der Ansprüche 1-10, **dadurch gekennzeichnet, dass** an dessen elektrischem Anschluss (3) ein elektrisches Anschlusselement (4) anschließbar ist, wobei das elektrische Anschlusselement (4) ein Gewinde aufweist, dass am Teilgewinde (10) anschraubbar ist.

12. Sicherheitstechnisches Elektronikmodul nach Anspruch 11, **dadurch gekennzeichnet, dass** der elektrische Anschluss (3) als Stecker oder Buchse ausgebildet ist, und dass komplementär hierzu das elektrische Anschlusselement (4) als Buchse oder Stecker ausgebildet ist.

13. Sicherheitstechnisches Elektronikmodul nach einem der Ansprüche 1-12, **dadurch gekennzeichnet, dass** dieses ein Sicherheitsschalter ist.

14. Sicherheitstechnisches Elektronikmodul nach einem der Ansprüche 1-13, **dadurch gekennzeichnet, dass** dieses ein Schnittstellenmodul (1) ist.
